# EUROPEAN PATENT APPLICATION

(11) **EP 4 109 555 A1**
(43) Date of publication of application: **28.12.2022**
(21) Application number: 22180471.9
(22) Date of filing: 22.06.2022
(51) Int. Cl.: H01L 29/66, H01L 21/8234, H01L 29/78, H01L 21/8238

(54) **FIN TO FIN TRENCH CONTACT THROUGH A METAL GATE CUT**

(30) Priority: 25.06.2021 US 202117358559
(71) Applicant: INTEL Corporation, Santa Clara, CA 95054 (US)
(72) Inventor: BOUCHE, Guillaume, Portland, 97211 (US); VYAS, Shashi, Euclid, 44123 (US); WEI, Andy Chih-Hung, Yamhill, 97148 (US); GULER, Leonard P., Hillsboro, 97124 (US)
(74) Representative: 2SPL Patentanwälte PartG mbB

(57) **Abstract**

Embodiments described herein may be related to apparatuses, processes, and techniques related to manufacturing a gate structure that includes adjacent gates that are coupled with the first fin and a second fin, with a metal gate cut across the adjacent gates and a trench connector between the adjacent gates that electrically couples the first fin and the second fin. Other embodiments may be described and/or claimed.

## Description

### FIELD

Embodiments of the present disclosure generally relate to the field of semiconductor packaging, and in particular to metal gate cuts within a transistor structure.

### BACKGROUND

Continued growth in virtual machines, cloud computing, and portable devices will continue to increase the demand for high density transistors within chips and packages.

### BRIEF DESCRIPTION OF THE DRAWINGS

FIG. 1 illustrates a legacy implementation of a metal gate cut with a trench contact (TCN) within a transistor structure.
FIGs. 2A-2F illustrate manufacturing stages of a transistor structure in a legacy implementation of a self-aligned contact (SAC) process.
FIGs. 3A-3C illustrate manufacturing stages in a legacy implementation of a SAC process that includes a metal gate cut.
FIG. 4 illustrates a legacy implementation of a transistor structure with a broken TCN due to a metal gate cut.
FIG. 5 shows a transistor structure with a TCN coupling two fins where the TCN is between a metal gate cut in two gates, in accordance with various embodiments.
FIGs. 6A-6H illustrate manufacturing stages in a SAC process to implement metal gate cuts across adjacent gates that includes dielectric refill between the adjacent gates, in accordance with various embodiments.
FIGs. 7A-7F illustrate manufacturing stages in another SAC process to implement metal gate cuts across adjacent gates that includes dielectric refill between the adjacent gates, in accordance with various embodiments.
FIG. 8 illustrates an example process for manufacturing a transistor structure with metal gate cuts across adjacent gates that include dielectric refill and TCN between the adjacent gates, in accordance with various embodiments.
FIG. 9 illustrates a computing device 900 in accordance with one implementation of the invention.
FIG. 10 illustrates an interposer 1000 that includes one or more embodiments of the invention.

### DETAILED DESCRIPTION

Embodiments described herein may be related to apparatuses, processes, and techniques directed to manufacturing a gate structure that includes adjacent gates that are coupled with the first fin and a second fin, with a metal gate cut across the adjacent gates and a trench connector (TCN) between the adjacent gates that electrically couples the first fin and the second fin. In embodiments, after a metal gate cut is implemented across the adjacent gates, an etchable material is grown between the faces of the cuts in the respective gates, a dielectric is regrown in a volume of the dielectric removed by the metal gate cut, and another dielectric replaces the etchable material. A TCN may then be placed within the dielectric between the two cuts in the adjacent gates. Other process embodiments may be disclosed herein.

In embodiments, a TCN pass-through may be enabled by a cell designer even though a metal gate cut is used across multiple gates. In embodiments, the process flows described herein may comport with known self-aligned contact (SAC) processes. For example, in embodiments, once a dielectric on dielectric deposition is performed within the metal gate cut, the manufacturing process may revert to known SAC processes, for example using nitride as a block during an oxide etch.

As complementary metal oxide semiconductor (CMOS) technology scales further, edge placement error (EPE) in a direction perpendicular to a gate may be facilitated by a SAC process scheme. Concurrently, the use of metal gate cuts in a direction perpendicular to a fin may facilitate scaling and increased component density, allowing for tighter Gate Extension past Fin critical dimension as well as tighter cut. In addition, a TCN implemented as a pass-through that allows a TCN to be routed past a metal gate cut to electrically couple one or more fins will further facilitate cell design, freeing interconnect at metal 0 or above from having to perform that connection.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

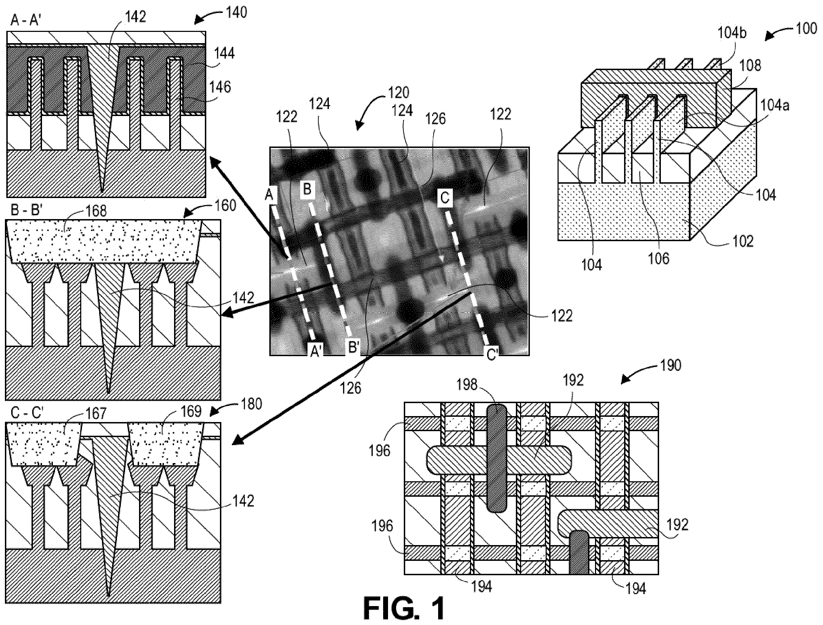

FIG. 1 illustrates legacy implementation of a metal gate cut with a TCN within a transistor structure. Transistor structure 100 illustrates a perspective view of a legacy gate structure that includes a silicon substrate 102 that is coupled with one or more fins 104 with a dielectric 106 separating the fins 104. A gate 108 is positioned across the plurality of fins 104, that separates a source side 104a of a fin 104 from a drain side 104b of a fin 104.

Transistor structure 120 shows a top-down view of a legacy structure that includes a number of metal gate cuts 122 through gates 124, which may be similar to gate 108, that are perpendicular to fins 126, which may be similar to fins 104.

Transistor structure 140 shows a side view along the cut of A-A' of transistor structure 120 top-down view. Transistor structure 140 shows a metal gate cut 142, which may be similar to metal gate cut 122, through gate 144, which may be similar to gate 124. The metal gate cut 142 goes completely through the gate 144, and is substantially parallel to the fins 146, which may be similar to fins 126.

Transistor structure 160 shows a side view along the cut of B-B' of transistor structure 120 top-down view. Transistor structure 160 shows a TCN pass-through 168 that has been placed over the metal gate cut 142. This proves that in that legacy process, the dielectric TCN patterning etches both silicon nitride and silicon oxide. The top of the TCN is located in a horizontal plane above the top of the metal gate of transistor structure 140. These features are indication that the patterning of the TCN was performed with no specific self-alignment scheme with respect to the gates.

Transistor structure 180 shows a side view along the cut of C-C' of transistor structure 120 top-down view. Transistor structure 180 shows metal gate cut 142 and two separate TCNs 167, 169.

Transistor structure 190 shows a diagram that includes multiple fins 196, which may be similar to fins 146, gates 194, which may be similar to gates 124, and metal gate cuts 192, which may be similar to metal gate cuts 122. As shown, a TCN 198, which may be similar to TCN 168 goes over the MGC.

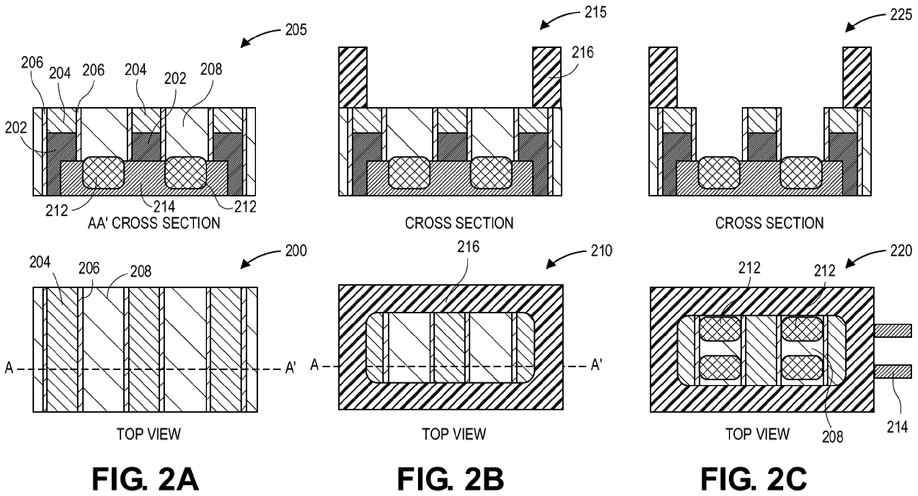

FIGs. 2A-2F illustrate manufacturing stages of a transistor structure in a legacy implementation of a self-aligned contact (SAC) process. FIG. 2A shows a top view 200 and a cross section 205 that includes a metal gate 202 with a gate cap 204 and that is surrounded by a gate spacer 206. The gate spacers 206 are separated by a dielectric 208. Epitaxies 212, which serve as a source or a drain, are positioned as raised extension of a fin structure 214. FIG. 2A represents a manufacturing stage after a gate formation and subsequent replacement metal gate process has been applied.

FIG. 2B shows a top view 210 and a cross-section 215 where a photoresist 216 is applied to a top of the transistor structure prior to etching.

FIG. 2C shows a top view 220, and a cross-section 225, where a selective SiO₂ etch has been applied to etch the dielectric 208 to expose the epitaxy 212. Note that the gate cap 204 and gate spacer 206 are unaffected since the etch selectively removes SiO₂ only. This step is called Self-Aligned Contact (SAC) etch since the resulting contact pattern between gates is not directly set by the opening in the resist resulting from photolithography but instead is self-aligned to the gate due to the selective nature of the etch. Implementing a SAC process for gate pitches smaller than 50nm will significantly reduce yield loss due to contact to gate electrical shorts.

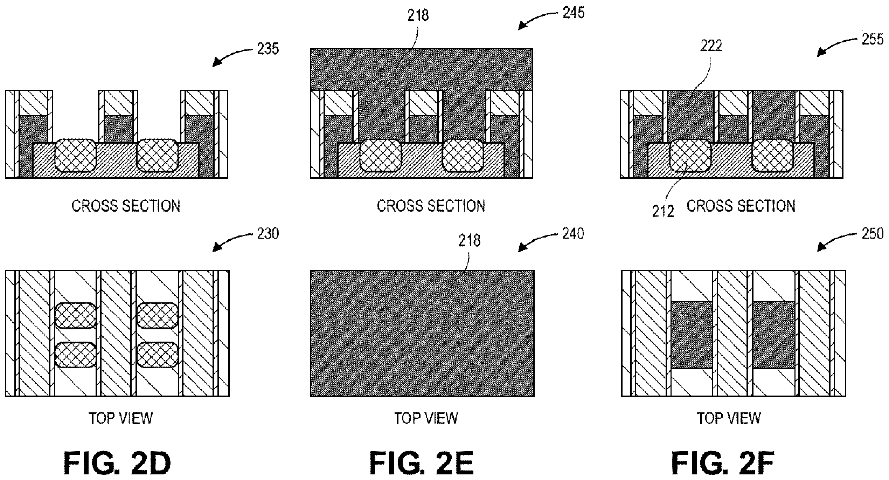

FIG. 2D shows a top view 230 and a cross-section 235 where the photoresist 216 has been removed.

FIG. 2E shows a top view 240 and a cross-section 245, where a contact metal fill 218 has been applied.

FIG. 2F shows a result of the transistor structure after a contact polish, where the contact metal fill 222 is coupled with the epitaxy 212. In embodiments, the contact metal fill 222 may serve as a TCN, as discussed further below.

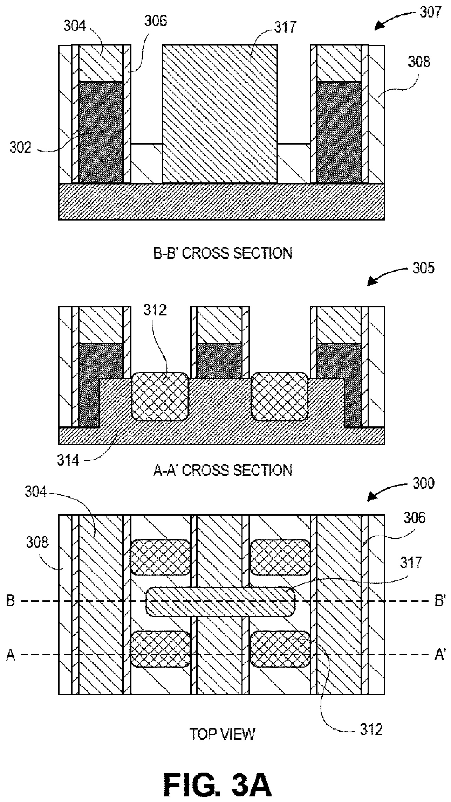

FIGs. 3A-3C illustrate manufacturing stages in a legacy implementation of a self-aligned contact process that includes a metal gate cut. FIGs. 3A-3C represent alternative manufacturing stages to FIGs. 2D-2F as described above.

FIG. 3A shows a top view 300 of the transistor structure, that may be similar to top view 230 of FIG. 2D. A metal gate 302 with a gate cap 304 is surrounded by a gate spacer 306. The gate spacers 306 are separated by a dielectric 308. Epitaxies 312, which serve as a source or a drain, are positioned as raised extensions of a fin structure 314. These may be similar to metal gate 202, gate cap 204, a gate spacer 206, dielectric 208, epitaxies 212, and fin structure 214 of FIGs. 2A-2F. A metal gate cut 317 is placed as shown in the B-B' cut line and refilled with silicon nitride (SiN). The transistor structure is also shown at a A-A' cross-section 305 and a B-B' cross-section 307.

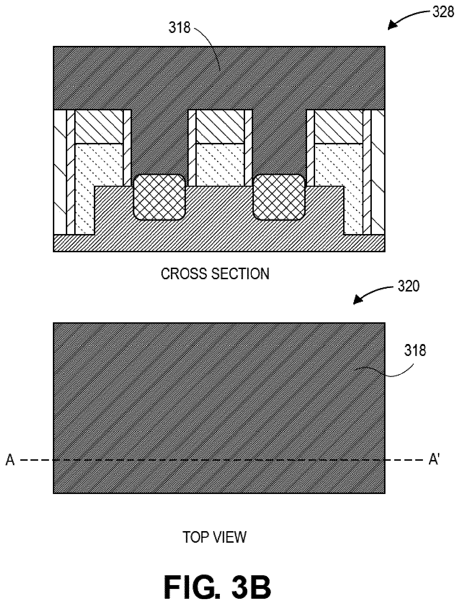

FIG. 3B shows a top view 320 and a cross-section at A-A' 328, where a contact metal fill 318 is deposited onto the transistor structure.

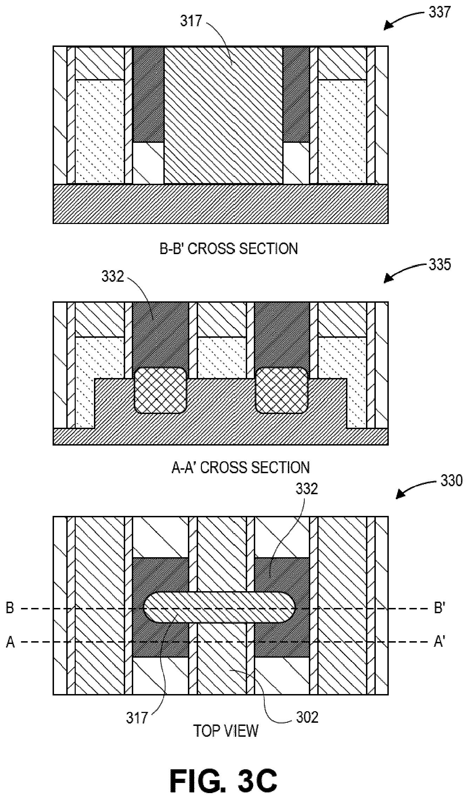

FIG. 3C shows a top view 330, a cross-section at A-A' 335, and a cross section at B-B' 337, after a contact polish has been performed. As shown, the resulting TCN 332 has been significantly encroached into by the metal gate cut 317. In other implementations, a metal gate cut such as 317 that was applied to multiple gates 302 would completely sever a TCN such as TCN 332. It should be noted that legacy SAC implementation requiring the contact etch to be selective to the gate cap, and by the same token to the material used to refill the metal gate cut, is not compatible as-is with the fabrication of a TCN pass-through.

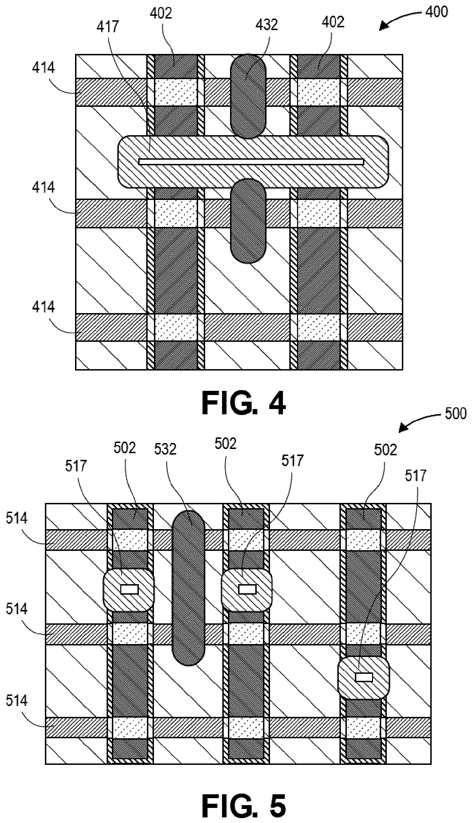

FIG. 4 illustrates a legacy implementation of a transistor structure with a broken TCN due to a metal gate cut. Transistor structure top-down view 400, which is similar to the transistor structure shown with respect to FIG. 3C, shows a metal gate cut 417 that cuts multiple gates 402 in a direction that is parallel to multiple fins 414. A trench connector 432, that is similar to trench connector 332 of FIG. 3C, in this case is completely severed by the metal gate cut 417, resulting in an electrical disconnection between two of the fins 414. In FIG. 3C, for clarity, the contacts are not shown as extending laterally to be in contact with the outer sides of the spacers; however, in embodiments, they may be in contact.

FIG. 5 shows a transistor structure with a TCN coupling two fins where the TCN is between a metal gate cut in two gates, in accordance with various embodiments. Transistor structure top-down view 500 shows a plurality of gates 502 that include cuts 517 within the gates 502. The gates 502 are substantially perpendicular with a plurality of fins 514. A TCN 532 is located in between the cuts 517 in the gates 502, and is shown as completely connecting two of the fins 514. The cuts 517 may be filled with a silicon nitride (SiN), in embodiments as discussed further below.

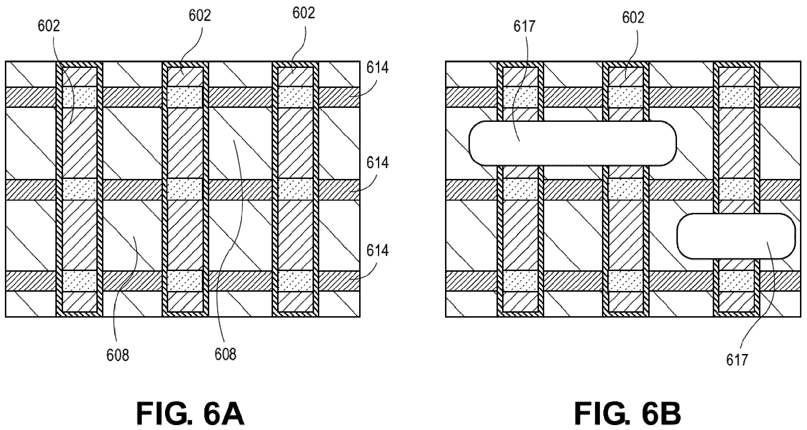

FIGs. 6A-6H illustrate manufacturing stages in a self-aligned contact process to implement metal gate cuts across adjacent gates that includes dielectric refill between the adjacent gates, in accordance with various embodiments.

FIG. 6A shows a top-down view of a transistor structure that includes a plurality of metal gates 602 that are in contact with a plurality of fins 614 with a dielectric 608 interspersed between the fins 614 and the metal gates 602. In embodiments, the top-down view of transistor structure of FIG. 6A is after a replacement metal gate process has been applied. Metal is therefore exposed at the top of the gate after the polishing.

FIG. 6B shows metal gate cuts 617, which may be similar to metal gate cut 417 of FIG. 4, applied to cut the one or more metal gates 602. In embodiments, the metal gate cut process may be a nonselective metal gate cut that removes all material, including dielectric material 608 and metal gate 602 material including a gate, gate dielectric, gate spacer and gate metal. Unlike FIG. 4 that shows the process after the cuts have been refilled by a dielectric, FIG. 6B represents the top view after the etch. The cuts 617 expose the silicon substrate at the base of the cuts. In embodiments, the width of the cuts may typically be in a range of 8nm to 50nm, or more narrowly be in a range of 12nm to 20nm.

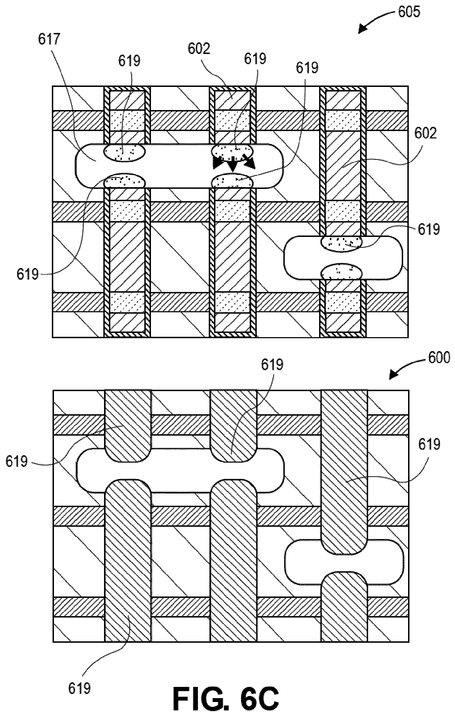

FIG. 6C shows top-down transistor structure view 600 that shows an organic passivation 619 grown on exposed metal of the gate 602 after the metal gate cut 617. In embodiments, this may be a passivation material that may be subsequently etched. View 605 shows a top-down transistor structure view just below the organic passivation 619 at the very top of the transistor structure. In embodiments, the passivation 619 may continue to be grown until the passivation layer 619 on either side of the metal gate 602 grow together as discussed below.

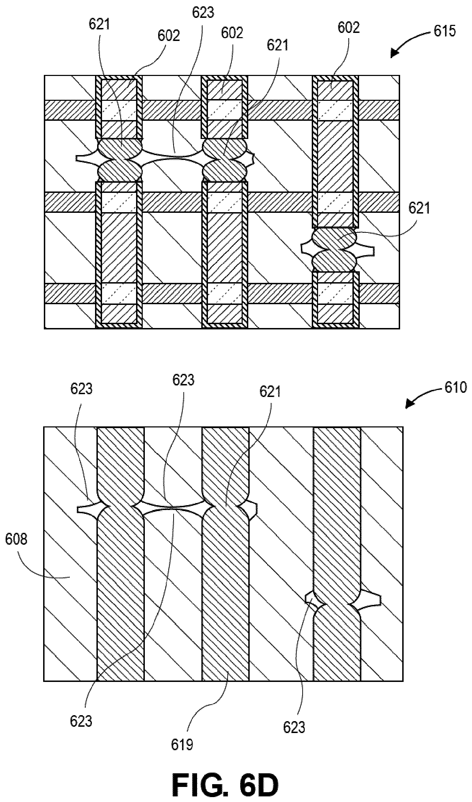

FIG. 6D shows a transistor structure top-down view 610, that shows the passivation layer 619, as well as the portion of the passivation layer 621 that has grown together at the level of the cuts in the metal gates 602. As shown, a dielectric material 623 has been deposited to fill in holes in the dielectric 608 that were made by the metal gate cut 617. In embodiments, the dielectric material 623 will fill in those areas other than the areas already refilled in by the passivation 619. Transistor structure top-down view 615 shows a top-down view just under the top passivation layer 621. In embodiments, the dielectric material 623 may be a silicon dioxide (SiO₂) material grown selectively on the dielectric 608. SiO₂ material using a dielectric on dielectric selective atomic-layer deposition technique.

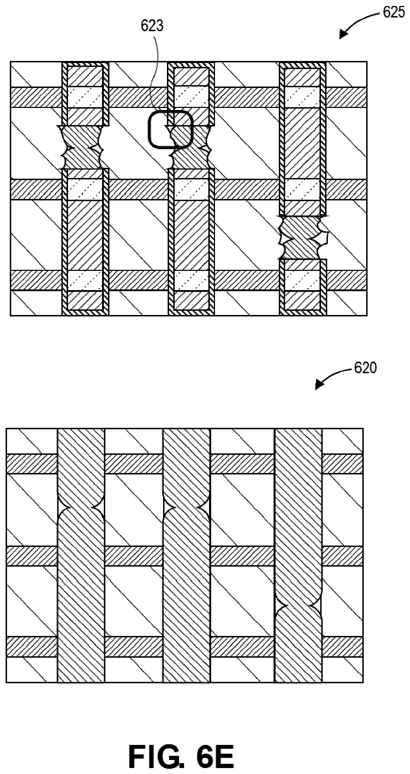

FIG. 6E shows a top-down view 620 and a top-down view just under the top passivation layer 625 of a continuation of the process described with respect to FIG. 6D, where the dielectric deposition 623 continues to fill in areas within the metal gate cut 617 that are not already filled in by the passivation layer deposition 621.

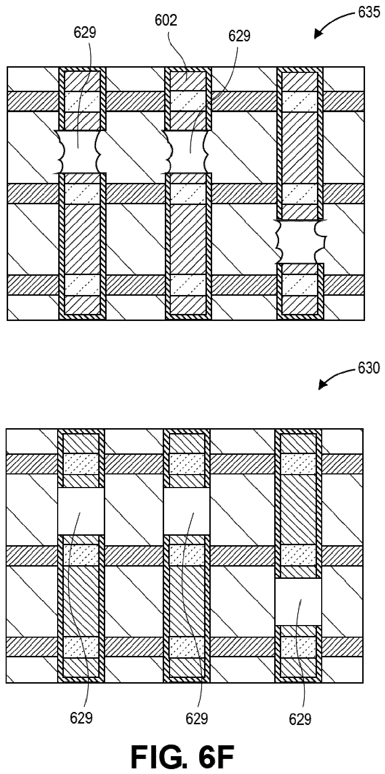

FIG. 6F shows a transistor structure top-down view 630, and top-down view 635 just below the top layer of the transition structure, where the passivation 619 has been stripped to leave cavities 629 between the cuts in the gate 602 made by the metal gate cut 617. In embodiments, an atomic layer deposition (ALD) SiO₂ deposition followed by isotropic SiO₂ etch, may be used to fill any seams and to widen the cavity 629. In embodiments, this may be done to prevent future shorts between a TCN to be deposited as described below, and the gate 602.

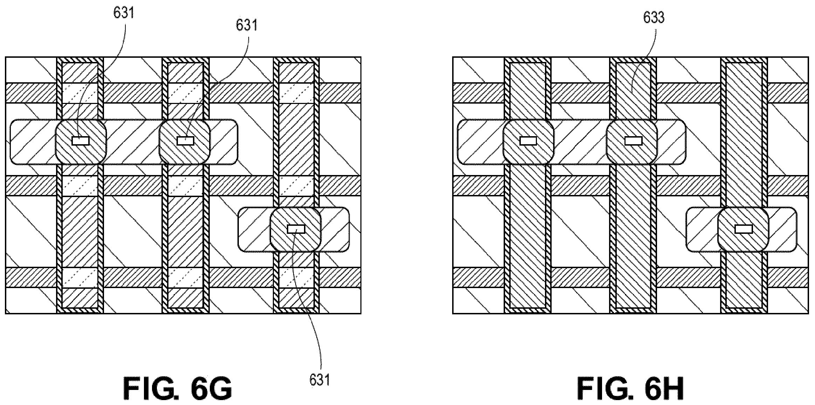

FIG. 6G shows a top-down view of a transistor structure where a gate cut plug 631 has been deposited into the cavity 629 of FIG. 6F. In embodiments, the gate cut plug 631 may be a conformal silicon nitride deposited using an Atomic-Layer Deposition (ALD) technique. FIG. 6G also shows the result of a chemical mechanical polish applied to the top of the transistor structure and used to polish away the excess ALD SiN deposited on top of the structure.

FIG. 6H shows a gate cap 633, which may be similar to gate cap 304 of FIG. 3. To manufacture this gate cap 633, a controlled selective metal etch has been applied to recess the gate stack followed by a SiN refill and a polishing. In embodiments, after the manufacturing stage showed with respect to FIG. 6H, a regular SAC process may be continued to further manufacture the transistor structure. This is because only oxide is now present in between the gates, and as seen from above the gates are covered, including at the location of the cuts, by silicon nitride, allowing to use a selective oxide etch to self-aligned TCN trenches with respect to gates and not rely on lithography to perform the pattern of each individual contact, in a manner similar to the one illustrated in FIG. 2. TCN pass-through can be manufactured even in between gate cuts.

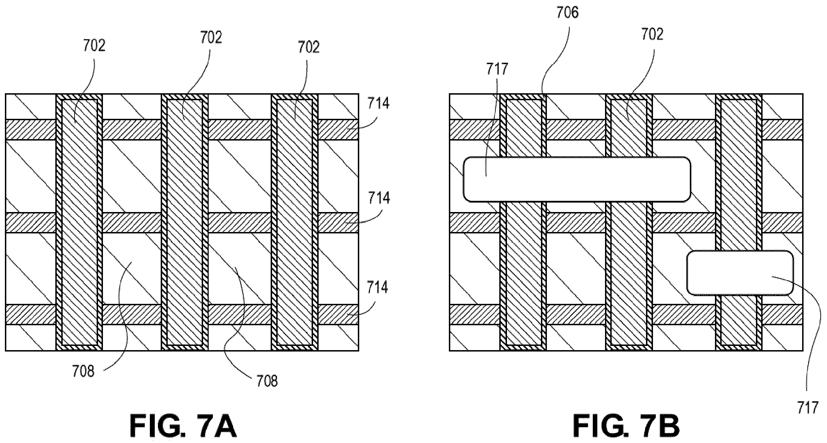

FIGs. 7A-7F illustrate manufacturing stages in another self-aligned contact process to implement metal gate cuts across adjacent gates that includes dielectric refill between the adjacent gates, in accordance with various embodiments.

FIG. 7A shows a top-down view of a transistor structure that includes a plurality of metal gates 702 that are in contact with a plurality of fins 714 with a dielectric 708 interspersed between the fins 714 and the metal gates 702. In embodiments, the top-down view of transistor structure of FIG. 7A is after a replacement metal gate process has been applied. Thereafter, the metal gates have been recessed and a SiN cap 204 processed in the recessed gate, as previously shown in cross section in FIG. 2A.

FIG. 7B shows metal gate cuts 717, which may be similar to metal gate cut 417 of FIG. 4, applied to cut the one or more metal gates 702. In embodiments, the metal gate cut process may be a nonselective metal gate cut that removes all material, including dielectric material 708, gate spacer 706 and metal gate 702 material including a gate, gate dielectric, and gate metal.

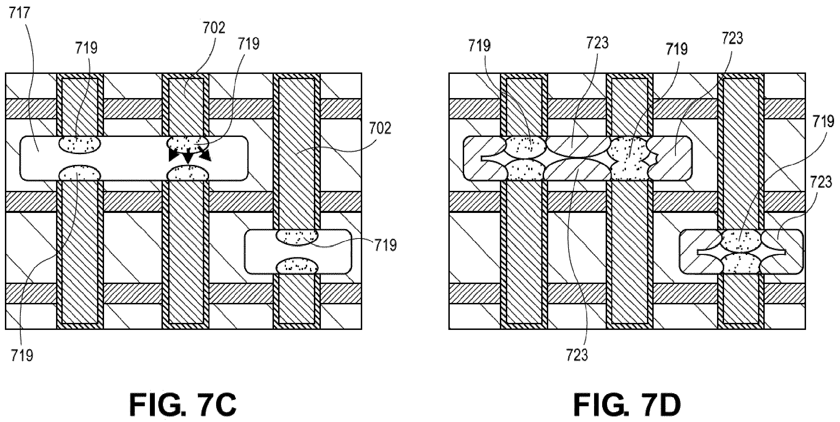

FIG. 7C shows top-down transistor structure view that shows a sacrificial metal 719 grown on exposed metal of the gate 702 after the metal gate cut 717, using a selective metal-on-metal Atomic-Layer-Deposition process. In embodiments, this may be a sacrificial Tungsten film that may be subsequently etched. In embodiments, the sacrificial metal 719 may continue to be grown until the sacrificial metal 719 on either side of the metal gate 702 grows together as discussed below.

FIG. 7D shows a transistor structure top-down view, that shows the sacrificial metal 719 that has grown together between the cuts in the metal gates 702. As shown, a dielectric material 723 has been grown using a selective dielectric on dielectric atomic-layer deposition process to fill in holes in the dielectric 708 that were made by the metal gate cut 717. In embodiments, the dielectric material 723 will fill in those areas other than the areas filled in by the sacrificial metal 719.

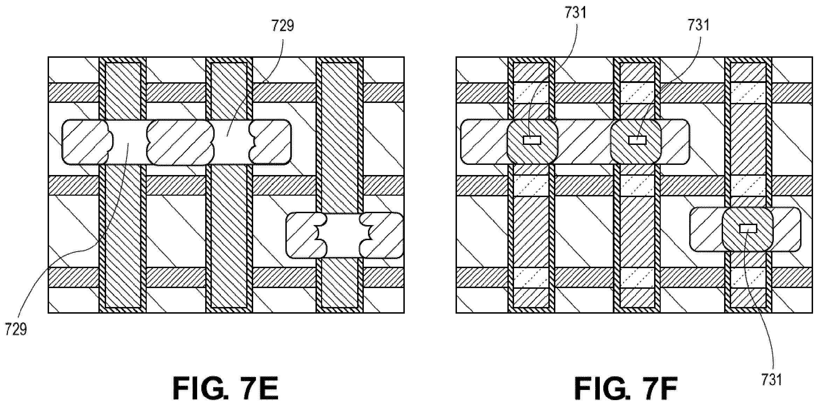

FIG. 7E shows a transistor structure top-down view where the sacrificial metal 719 has been etched selectively to the gate cap and to the dielectric 708 and the grown dielectric 723 to leave cavities 729 between the cuts in the gate 702 made originally by the non-selective metal gate cut 717. In embodiments, an anisotropic tungsten (W) etch may be performed.

FIG. 7F shows a top-down view of a transistor structure where a gate cut plug 731 has been deposited into the cavity 729 of FIG. 7E. In embodiments, the gate cut plug 731 material may be a conformal silicon nitride deposited using an Atomic-Layer Deposition technique. FIG. 7F also shows the result of a chemical mechanical polish applied to the top of the transistor structure so as to remove the silicon nitride that had been deposited by the ALD on top of the structure. A regular SAC process may be continued to further manufacture the transistor structure.

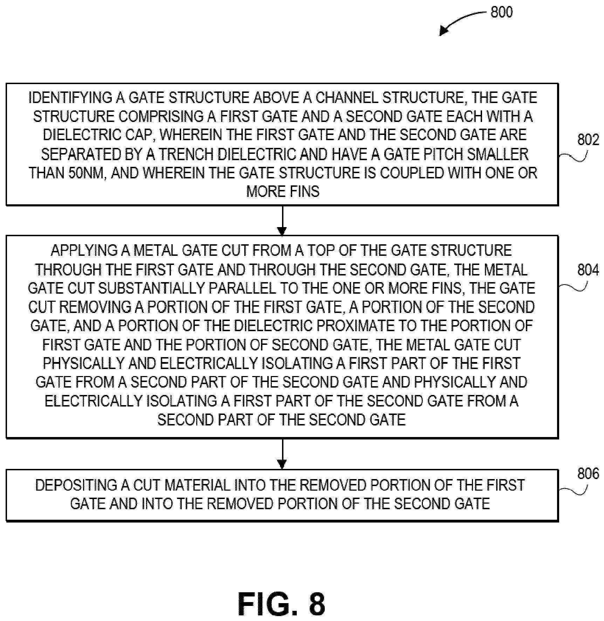

FIG. 8 illustrates an example process for manufacturing a transistor structure with metal gate cuts across adjacent gates that include dielectric refill and TCN between the adjacent gates, in accordance with various embodiments.

At block 802, the process may include identifying a gate structure above a channel structure, the gate structure comprising a first gate and a second gate separated by a trench dielectric, the gate structure coupled with one or more fins.

At block 804, the process may further include applying a non-selective metal gate cut from a top of the gate structure through the first gate and through the second gate, the metal gate cut substantially parallel to the one or more fins, the gate cut removing a portion of the first gate, a portion of the second gate, and a portion of the dielectric proximate to the portion of first gate and the portion of second gate, the metal gate cut physically and electrically isolating a first part of the first gate from a second part of the second gate and physically and electrically isolating a first part of the second gate from a second part of the second gate.

At block 806, the process may further include depositing a cut material into the removed portion of the first gate and into the removed portion of the second gate.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the spirit and scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or gate-all-around transistors such as nanoribbon and nanowire transistors. Although the implementations described herein may illustrate only Finfet transistors, it should be noted that the invention may also be carried out using planar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO2) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

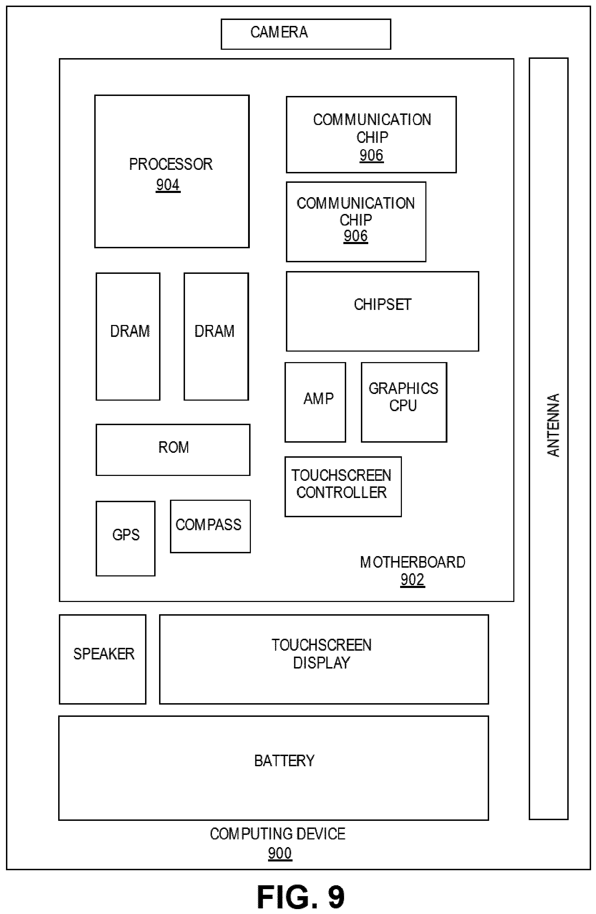

FIG. 9 illustrates a computing device 900 in accordance with one implementation of the invention. The computing device 900 houses a board 902. The board 902 may include a number of components, including but not limited to a processor 904 and at least one communication chip 906. The processor 904 is physically and electrically coupled to the board 902. In some implementations the at least one communication chip 906 is also physically and electrically coupled to the board 902. In further implementations, the communication chip 906 is part of the processor 904.

Depending on its applications, computing device 900 may include other components that may or may not be physically and electrically coupled to the board 902. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 906 enables wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing device 900 includes an integrated circuit die packaged within the processor 904. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 906 also includes an integrated circuit die packaged within the communication chip 906. In accordance with another implementation of the invention, the integrated circuit die of the communication chip includes one or more devices, such as MOS-FET transistors built in accordance with implementations of the invention.

In further implementations, another component housed within the computing device 900 may contain an integrated circuit die that includes one or more devices, such as MOS-FET transistors built in accordance with implementations of the invention.

In various implementations, the computing device 900 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 900 may be any other electronic device that processes data.

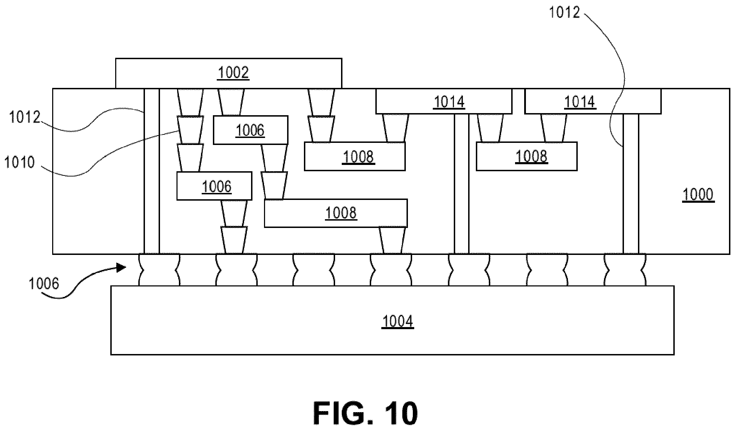

FIG. 10 illustrates an interposer 1000 that includes one or more embodiments of the invention. The interposer 1000 is an intervening substrate used to bridge a first substrate 1002 to a second substrate 1004. The first substrate 1002 may be, for instance, an integrated circuit die. The second substrate 1004 may be, for instance, a memory module, a computer motherboard, or another integrated circuit die. Generally, the purpose of an interposer 1000 is to spread a connection to a wider pitch or to reroute a connection to a different connection. For example, an interposer 1000 may couple an integrated circuit die to a ball grid array (BGA) 1006 that can subsequently be coupled to the second substrate 1004. In some embodiments, the first and second substrates 1002/1004 are attached to opposing sides of the interposer 1000. In other embodiments, the first and second substrates 1002/1004 are attached to the same side of the interposer 1000. And in further embodiments, three or more substrates are interconnected by way of the interposer 1000.

The interposer 1000 may be formed of an epoxy resin, a fiberglass-reinforced epoxy resin, a ceramic material, or a polymer material such as polyimide. In further implementations, the interposer 1000 may be formed of alternate rigid or flexible materials that may include the same materials described above for use in a semiconductor substrate, such as silicon, germanium, and other group III-V and group IV materials.

The interposer 1000 may include metal interconnects 1008 and vias 1010, including but not limited to through-silicon vias (TSVs) 1012. The interposer 1000 may further include embedded devices 1014, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 1000. In accordance with embodiments of the invention, apparatuses or processes disclosed herein may be used in the fabrication of interposer 1000.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize.

These modifications may be made to the embodiments in light of the above detailed description. The terms used in the following claims should not be construed to limit the embodiments to the specific implementations disclosed in the specification and the claims. Rather, the scope of the invention is to be determined entirely by the following claims, which are to be construed in accordance with established doctrines of claim interpretation.

The following paragraphs describe examples of various embodiments.

### EXAMPLES

Example 1 is an integrated circuit structure, comprising: a gate structure having a first gate and a second gate, the first gate and the second gate substantially parallel and separated by a dielectric material, a pitch between the first gate and the second gate less than 50nm, and wherein the gates include a cap; a first cut region in the first gate that physically and electrically isolates a first portion of the first gate from a second portion of the first gate, wherein the first portion of the first gate is coupled with a first fin, and the second portion of the first gate is coupled with a second fin; a second cut region in the second gate that physically and electrically isolates a first portion of the second gate from a second portion of the second gate, wherein the first portion of the second gate is coupled with the first fin, and the second portion of the second transistor gate is coupled with the second fin; wherein the first cut and the second cut are physically separated by the dielectric; and a trench contact located completely within the dielectric and between the first cut region in the first gate and the second cut region in the second gate, wherein the trench contact couples the first fin and the second fin.

Example 2 may include the integrated circuit structure of example 1, wherein the first cut region and the second cut region are filled with a cut dielectric.

Example 3 may include the integrated circuit structure of example 2, wherein the cut dielectric includes silicon and nitrogen.

Example 4 includes the integrated circuit structure of example 1, wherein the trench contact is electrically coupled with the first fin and the second fin.

Example 5 includes the integrated circuit structure of example 1, wherein the first cut region in the first gate extends completely through the first gate, and wherein the second cut region in the second gate extends completely through the second gate.

Example 6 includes the integrated circuit structure example 1, wherein the first cut region and the second cut region are substantially parallel to the first fin or to the second fin.

Example 7 includes the integrated circuit structure example 1, wherein the first cut region and the second cut region extend into a substrate beneath the first gate and the second gate.

Example 8 includes the integrated circuit structure of example 1, wherein the trench connector is electrically coupled with a third fin.

Example 9 includes the integrated circuit structure of example 1, wherein a material of the cap includes a selected one of: the dielectric or a metal oxide.

Example 10 includes the integrated circuit structure of example 1, wherein a material of the first gate and the second gate include Lanthanum.

Example 11 includes the integrated circuit structure of example 1, where a material of the trench contact includes a selected one or more of: Cobalt, Molybdenum, Tungsten, or Ruthenium.

Example 12 includes the integrated circuit structure of example 1 wherein a width of the trench contact is less than 15 nm.

Example 13 includes the integrated circuit structure of any one of examples 1-12, wherein a width of gate cut width is smaller than 18nm.

Example 14 includes a method, comprising: identifying a gate structure above a channel structure, the gate structure comprising a first gate and a second gate each with a dielectric cap, wherein the first gate and the second gate are separated by a trench dielectric and have a gate pitch smaller than 50nm, and wherein the gate structure is coupled with one or more fins; applying a metal gate cut from a top of the gate structure through the first gate and through the second gate, the metal gate cut substantially parallel to the one or more fins, the gate cut removing a portion of the first gate, a portion of the second gate, and a portion of the dielectric proximate to the portion of first gate and the portion of second gate, the metal gate cut physically and electrically isolating a first part of the first gate from a second part of the second gate and physically and electrically isolating a first part of the second gate from a second part of the second gate; and depositing a cut material into the removed portion of the first gate and into the removed portion of the second gate.

Example 15 includes the method of example 14, wherein depositing the cut material into the removed portion of the first gate and into the removed portion of the second gate further comprises: depositing a first material between a first face and a second face of the metal gate cut of the first gate and between a first face and a second face of the metal gate cut of the second gate, wherein the first material between the first face in the second face of the metal gate cut are directly physically coupled; selectively depositing a second material in the removed portion of the dielectric proximate to the removed portion of the first gate and the removed portion of the second gate; removing the first material; and depositing the cut material into a volume created by the removed first material.

Example 16 includes the method of any one of examples 14-15, wherein the first material is an organic passivation layer.

Example 17 includes the method of any one of examples 14-15, wherein the second material includes silicon and oxygen.

Example 18 includes the method of example 17, wherein the second material is grown on a trench dielectric.

Example 19 includes the method of any one of examples 14-18, wherein the first material is a metal.

Example 20 includes the method of any one of examples 14-18, wherein the cut material includes silicon or nitrogen.

Example 21 includes a package comprising: a plurality of transistor structures, a transistor structure comprising: a gate structure having a first gate and a second gate, the first gate and the second gate substantially parallel and separated by a dielectric material; a first cut region in the first gate that physically and electrically isolates a first portion of the first gate from a second portion of the first gate, wherein the first portion of the first gate is coupled with a first fin, and the second portion of the first gate is coupled with a second fin; a second cut region in the second gate that physically and electrically isolates a first portion of the second gate from a second portion of the second gate, wherein the first portion of the second gate is coupled with the first fin, and the second portion of the second gate is coupled with the second fin; wherein the first cut and the second cut are physically separated by the dielectric; and a trench contact located completely within the dielectric and between the first cut region in the first gate and the second cut region in the second gate; and a computing device coupled with the integrated circuit structure.

Example 22 includes the package of example 21, wherein the first fin and the second fin are part of a FinFET.

Example 23 includes the package of example 21, wherein the first cut region and the second cut region are filled with silicon or nitrogen.

Example 24 includes the package of example 21, further comprising: a device electrically coupled with the plurality of transistor structures, wherein the plurality of transistor structures control electrical signals sent to the device.

Example 25 includes the package of example 21, wherein the first gate and the second gate includes silicon.

## Claims

1. An integrated circuit structure, comprising:
a gate structure having a first gate and a second gate, the first gate and the second gate substantially parallel and separated by a dielectric material, a pitch between the first gate and the second gate less than 50nm, and wherein the gates include a cap;
a first cut region in the first gate that physically and electrically isolates a first portion of the first gate from a second portion of the first gate, wherein the first portion of the first gate is coupled with a first fin, and the second portion of the first gate is coupled with a second fin;
a second cut region in the second gate that physically and electrically isolates a first portion of the second gate from a second portion of the second gate, wherein the first portion of the second gate is coupled with the first fin, and the second portion of the second transistor gate is coupled with the second fin;
wherein the first cut and the second cut are physically separated by the dielectric; and
a trench contact located completely within the dielectric and between the first cut region in the first gate and the second cut region in the second gate, wherein the trench contact couples the first fin and the second fin.

2. The integrated circuit structure of claim 1, wherein the first cut region and the second cut region are filled with a cut dielectric.

3. The integrated circuit structure claim 2, wherein the cut dielectric includes silicon and nitrogen.

4. The integrated circuit structure of one of the previous claims, wherein the trench contact is electrically coupled with the first fin and the second fin.

5. The integrated circuit structure of one of the previous claims, wherein the first cut region in the first gate extends completely through the first gate, and wherein the second cut region in the second gate extends completely through the second gate.

6. The integrated circuit structure of one of the previous claims, wherein the first cut region and the second cut region are substantially parallel to the first fin or to the second fin.

7. The integrated circuit structure of one of the previous claims, wherein the first cut region and the second cut region extend into a substrate beneath the first gate and the second gate.

8. The integrated circuit structure of one of the previous claims, wherein the trench connector is electrically coupled with a third fin.

9. The integrated circuit structure of claim 1, wherein a material of the cap includes a selected one of: the dielectric or a metal oxide.

10. The integrated circuit structure of one of the previous claims, wherein a material of the first gate and the second gate include Lanthanum.

11. The integrated circuit structure of one of the previous claims, where a material of the trench contact includes a selected one or more of: Cobalt, Molybdenum, Tungsten, or Ruthenium.

12. The integrated circuit structure of one of the previous claims, wherein a width of the trench contact is less than 15 nm.

13. The integrated circuit structure of one of the previous claims, wherein a width of gate cut width is smaller than 18nm.

14. A method, comprising:
identifying a gate structure above a channel structure, the gate structure comprising a first gate and a second gate each with a dielectric cap, wherein the first gate and the second gate are separated by a trench dielectric and have a gate pitch smaller than 50nm, and wherein the gate structure is coupled with one or more fins;
applying a metal gate cut from a top of the gate structure through the first gate and through the second gate, the metal gate cut substantially parallel to the one or more fins, the gate cut removing a portion of the first gate, a portion of the second gate, and a portion of the dielectric proximate to the portion of first gate and the portion of second gate, the metal gate cut physically and electrically isolating a first part of the first gate from a second part of the second gate and physically and electrically isolating a first part of the second gate from a second part of the second gate; and
depositing a cut material into the removed portion of the first gate and into the removed portion of the second gate.

15. The method of claim 14, wherein depositing the cut material into the removed portion of the first gate and into the removed portion of the second gate further comprises:
depositing a first material between a first face and a second face of the metal gate cut of the first gate and between a first face and a second face of the metal gate cut of the second gate, wherein the first material between the first face in the second face of the metal gate cut are directly physically coupled;
selectively depositing a second material in the removed portion of the dielectric proximate to the removed portion of the first gate and the removed portion of the second gate;
removing the first material; and
depositing the cut material into a volume created by the removed first material.
